# EUROPEAN PATENT APPLICATION

(11) **EP 1 786 036 A1**
(43) Date of publication of application: **16.05.2007**
(21) Application number: 05110648.2
(22) Date of filing: 11.11.2005
(51) Int. Cl.: H01L 27/115, H01L 21/8247

(54) **Floating gate non-volatile memory cell and process for manufacturing**

(71) Applicant: STMicroelectronics S.r.l., 20041 Agrate Brianza (Milano) (IT)
(72) Inventor: Cremonesi, Carlo, I-20069, Vaprio d'Adda (MI) (IT); Pavan, Alessia, I-23807, Merate (LC) (IT); Servalli, Giorgio, I-24040, Liserano (BG) (IT)
(74) Representative: Maccalli, Marco

(57) **Abstract**

A process for manufacturing a non-volatile memory cell including a floating gate MOS transistor, comprising the steps of: forming a gate dielectric (**290**) over a surface (**210**) of a semiconductor material layer (**200**); forming a conductive floating gate electrode (**280**) insulated from the semiconductor material layer by the gate dielectric; forming at least one isolation region (**270**) laterally to said floating gate electrode; excavating the at least one isolation region; filling the excavated isolation region with a conductive material; and forming a conductive control gate electrode (**260**) of the floating gate MOS transistor insulatively over the floating gate, wherein the step of forming the floating gate electrode includes: laterally aligning said floating gate electrode to the at least one isolation region; and the step of excavating includes: lowering an isolation region exposed surface below a floating gate electrode exposed surface, said lowering exposing walls of the floating gate electrode; forming a protective layer on exposed walls of the floating gate electrode; and etching the at least one isolation region essentially down to the gate dielectric, the protective layer protecting against etching a portion of the at least one isolation region near the gate dielectric.

## Description

### Field of the invention

The present invention generally relates to semiconductor devices and to methods for their manufacturing. In particular, the invention relates to floating gate non-volatile MOS memory devices and to methods for the manufacturing thereof.

### Background art

The past approaches described in the following could be pursued, but are not necessarily approaches that have been previously conceived or pursued. Therefore, unless otherwise indicated herein, the approaches described in the following are not to be considered prior art to the claims in this application merely due to the presence of these approaches in the following background description.

In the last years, the demand of increasing the semiconductor device integration density has brought to reduce the size of the elements used in integrated circuits.

For example, a semiconductor memory device which is commonly used in a number of applications to store information (either temporarily or permanently) should be able to store as many data as possible. Since semiconductor memory devices include large matrixes of memory cells, a high memory cell density is required in order to increasing the storage capacity of the semiconductor memory device and, at the same time, keeping the die size limited; the lower the size of the memory cells, the higher the memory cell density achievable.

On the other hand, the storage capacity of semiconductor memory devices can also be increased by providing memory cells each capable to storage more than just one bit of data, for example two or more data bits.

In particular, Flash semiconductor memory devices include matrixes of floating gate MOS transistors. The floating gate MOS transistor used to form a Flash memory cell essentially is a MOSFET (acronym for Metal-Oxide-Semiconductor Field Effect Transistor) having a gate electrode consisting of a conductive control gate, a dielectric layer, a conductive floating gate and a tunnel oxide layer which are stacked over an active area (*i.e.,* a channel region) of the MOS transistor.

Floating gate MOS transistors may store a logic value defined by their threshold voltage. The threshold voltage may be set to different levels, each one representing corresponding logical values stored in the memory cell. Particularly, in a two level flash memory the generic memory cell has a threshold voltage that can be set in either one of two different levels, thus enabling storage of one bit of data; in a multi-level (*e.g*., four-level) flash memory the threshold voltage of the generic cell may be set in more than two (for example, four) different levels, thus allowing to store a plurality of (*e.g*., two) bits of data.

The threshold voltage depends on the electric charge on the floating gate, and it may be modified by injecting charge carriers, particularly electric charges like electrons into, or removing them from the floating gate. More in detail, a programming operation consists in the injection of electrons in the floating gate of the Flash memory cell, through a mechanism of tunneling across tunnel oxide (Fowler-Nordheim tunneling effect) or through a mechanism of injection of channel electrons "heated" by a suitable biasing voltage applied across the source and drain terminals (hot electrons programming). An erasing operation consists in the removal of electrons from the floating gate of the Flash memory cell, through a mechanism of tunneling across tunnel oxide (Fowler-Nordheim tunneling effect) with reverse voltage respect to programming.

In a Flash semiconductor memory device, the memory cells may be arranged according to either a NAND or a NOR architecture.

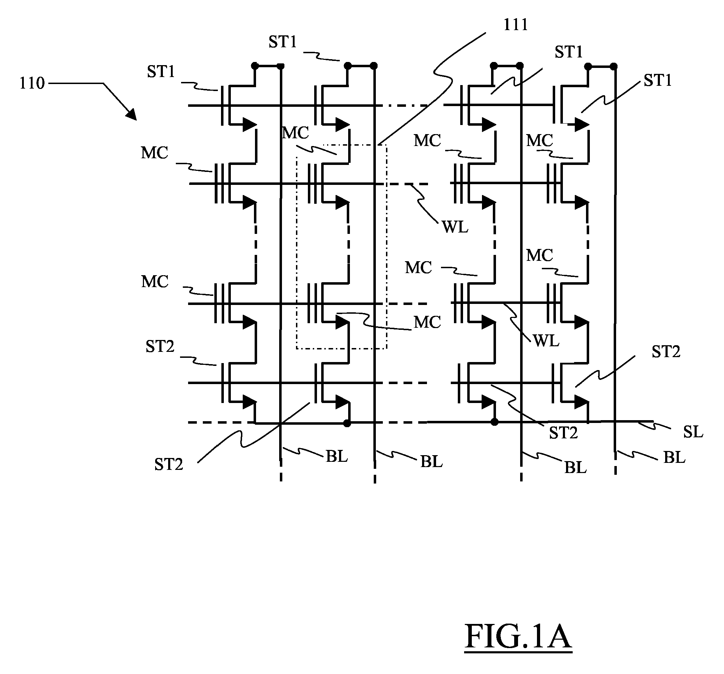

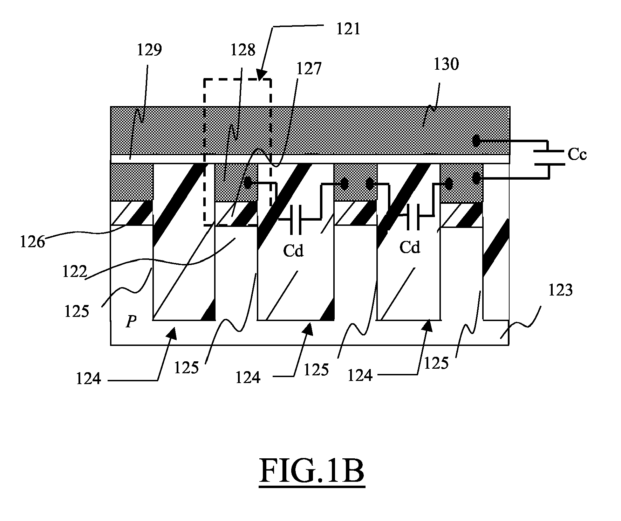

In **Figures 1A** and **1B** there are by way of example described a matrix portion **110** of a NAND flash memory, and a cross section along a word line of the matrix portion **110** according to the prior art.

In the memory matrix, the memory cells, labelled **MC**, are conventionally arranged by rows and columns, with the memory cells belonging to a same row sharing a control gate, formed by a conductive word line strip **WL**.

In the exemplary case considered of a NAND architecture, the memory cells of a same column are also grouped in a plurality of strings **111**. Within each string **111**, the memory cells **MC** (for example, 32 in number) are connected in series to each other between two select transistors **ST1** and **ST2,** selectively enabling the connection of the string to a respective bit line **BL**, respectively to a source line **SL**. As visible in **Figure 1B,** each memory cell is a floating gate MOS transistor having a gate electrode **121** completely self-aligned with an active region **122,** formed in a (*e.g.*, *P* type) substrate region **123**, laterally delimited and separated from the active region of the adjacent memory cell(s) by STI (Shallow Trench Isolation) isolation regions **124**. The generic isolation region **124** is formed by a corresponding trench **125**, extending from a main surface **126** of the substrate region **123** to a trench depth, filled by one or more layers of silicon oxide.

The gate electrode **121** consists of a thin silicon oxide layer **127,** forming the tunnel oxide, a polysilicon floating gate **128,** an interpoly dielectric layer **129** and a polysilicon control gate **130,** which are stacked on the active region **122** and self-aligned thereto.

The use of the STI isolation regions allows reducing the memory matrix area compared to other isolation techniques. A further reduction of the memory matrix area is made possible by the adoption of the NAND architecture, which substantially reduces the number of contacts.

With reference to **Figure 1A,** during the reading operation, the select transistors **ST1** and **ST2** of the generic selected string **111** are turned on, the word line **WL** of the matrix row including the selected memory cell **MC** to be read is brought to a reading voltage while the other word lines are brought to a voltage sufficiently high to ensure that the corresponding memory cells **MC** are conductive irrespective of their threshold voltage. The selected memory cell **MC** is conductive if its threshold voltage is lower than the reading voltage, otherwise it is not conductive.

Due to the coupling capacitances **Cd** (shown in **Figure 1B)** between the floating gates of adjacent cells, the actual potential which is applied to the floating gate of the selected cell through the coupling capacitance **Cc** with the control gate may result different from the expected one. As a consequence, the reading of the selected memory cell **MC** may be erroneous (for example, a memory cell that should be read as programmed may erroneously be considered erased). In other words, the capacitive coupling between the floating gates of adjacent cells makes the threshold voltage of the selected memory cell to depend not only on the electric charge stored in its floating gate, but also on the electric charges stored in the floating gates of the adjacent cells. Such effect modifies the threshold voltage of the cells when the adjacent cells are programmed.

The above mentioned problem is also experienced during programming of the memory cells: for example, if a generic memory cell is verified as programmed at a certain stage of a program sequence, it may then be read as non-programmed when the program sequence is completed and the adjacent memory cells have been programmed as well.

The disturbing effect described above is higher the higher the ratio between the coupling capacitance **Cd** with the floating gates of adjacent cells and the coupling capacitance **Cc** with the control gate.

The disturbs caused by the floating gate of the adjacent cells are in particular dangerous in multi-level memories, since the margins available for discriminating the different stored logic values are smaller.

The problem is exacerbated by the reduction of the width of the STI trenches, because this increases the coupling capacitances **Cd** between the floating gates of adjacent cells.

The above discussed problem has been addressed in the United States patent application US 2004/0012998, which discloses a NAND flash memory structure wherein, thanks to the fact that the word lines extend down between floating gates into isolation trenches until, within or past the level of gate oxide layer, thereby the word lines provide shielding from potentials in adjacent strings undergoing programming.

### Summary of the invention

The Applicant has tackled the problem of disturbs occurring during the reading operation of the memory device.

According to an aspect of the present invention, a solution is provided for manufacturing a self-aligned floating gate flash memory cell that, when inserted in a memory cell matrix, is less affected by disturbs induced by adjacent memory cells.

Particularly, an aspect of the present invention proposes a process for manufacturing a non-volatile memory cell including a floating gate MOS transistor, comprising the steps of: forming a gate dielectric over a surface of a semiconductor material layer; forming a conductive floating gate electrode insulated from the semiconductor material layer by the gate dielectric; forming at least one isolation region laterally to said floating gate electrode; excavating the at least one isolation region; filling the excavated isolation region with a conductive material, and forming a conductive control gate electrode of the floating gate MOS transistor insulatively over the floating gate. The step of forming the floating gate electrode includes laterally aligning said floating gate electrode to the at least one isolation region. The step of excavating includes: lowering an isolation region exposed surface below a floating gate exposed surface, said lowering exposing walls of the floating gate electrode; forming a protective layer on exposed walls of the floating gate electrode; and etching the at least one isolation region essentially down to the gate dielectric, the protective layer protecting against etching a portion of the isolation region near the gate dielectric.

### Brief description of the drawings

The present invention, as well as further features and the advantages thereof will be best understood by reference to the following detailed description, given purely by way of a non-restrictive indication, to be read in conjunction with the accompanying drawings, wherein:
**Figure 1A** schematically shows exemplary representations of a portion of a memory device according to the prior art;
**Figure 1B** shows a cross-sectional view along a word line of a matrix portion according to the prior art;
**Figures 2A** through **2L** are cross-sectional views illustrating the main steps of a manufacturing process of a floating gate MOS transistor according to a first embodiment of the present invention; and
**Figures 3A** through **3B** are cross-sectional views illustrating the main steps of a manufacturing process of a floating gate MOS transistor according to a second embodiment of the present invention.

### Detailed description

In the following description, it should be noted that the drawings are not in scale: relative dimensions and proportions of parts of the drawings may have been increased or reduced in size for the sake of clarity.

It is pointed out that although in the drawings and in the following description the particular case of a NAND memory cell matrix is considered, this is not to be construed as a limitation of the invention, which can for example be straightforwardly applied to NOR memory cell matrixes.

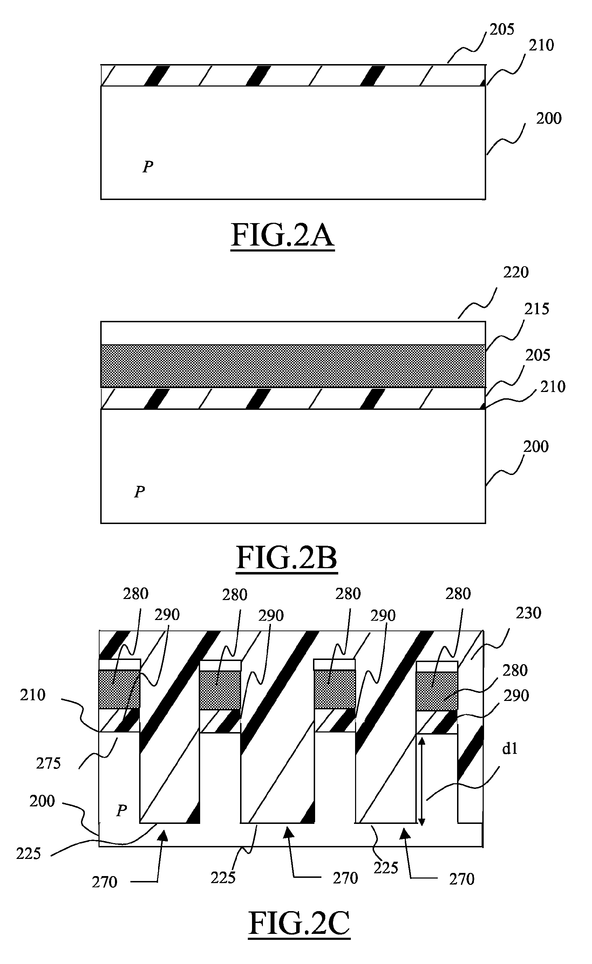

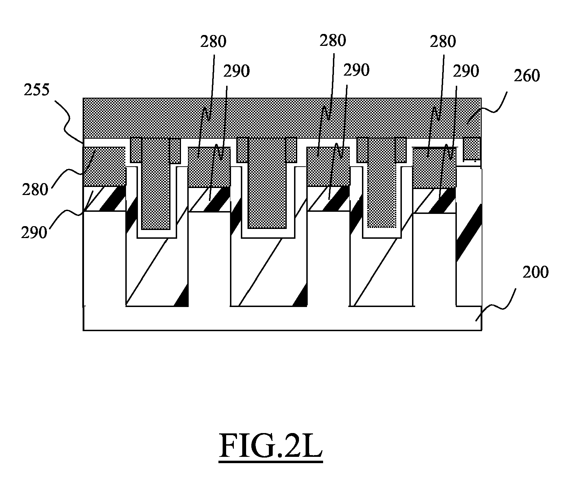

Referring to **Figures 2A** through **2L**, a floating-gate MOS transistor memory cell manufacturing process according to a first embodiment of the present invention is described herein below; in particular the drawings are cross-sectional views of a portion of a memory cell matrix made along a matrix row, *i.e.* along a generic word line.

Considering in particular **Figure 2A,** the starting material is a semiconductor substrate **200,** for example it may be a silicon wafer substrate of the *P* conductivity type, or a doped well, formed (possibly by means of a dedicated dopant implantation) inside a semiconductor layer, having for example a surface dopant concentration in the memory cell matrix ranging from approximately 5*10¹⁷ ions/cm³ to approximately 5*10¹⁹ ions/cm³.

Successively, a tunnel oxide layer **205**, for example with a thickness ranging from 6nm to 10nm is formed on top of a main surface **210** of the substrate **200.** Preferably, the tunnel oxide layer **205** consists of a thermally grown silicon oxide layer; alternatively, it may be a silicon oxide layer which is deposited for example by means of a CVD (acronym for Chemical Vapor Deposition) process.

Moving to **Figure 2B,** a polysilicon layer **215** and a nitride layer **220** are deposited on the tunnel oxide layer **205**, for example by means of a CVD process. The polisilicon layer **215** (possibly doped) is adapted for forming the floating gates of the floating gate MOS transistors, while the silicon nitride layer **220** is used as hard mask for the subsequent defmition of the isolation regions and/or as a stopping layer for the subsequent CMP (acronym for Chemical Mechanical Planarization) processes.

Moving the **Figure 2C**, trenches **225**, extending from the main surface **210** of the substrate region **200** down to an isolation depth **d1** (for example, ranging from 100nm to 300nm), are excavated by selectively etching the layers **220, 215, 205** and **200.** In particular, in order to form the trenches **225,** a photoresist mask (not shown in the figure) is provided on the silicon nitride layer **220,** so as to leave exposed areas of the layer **220** where the trenches **225** are to be formed. The nitride layer **220** is then selectively removed from such exposed areas, and the photoresist mask is stripped off; the remaining portions of nitride layer **220** form the hard mask for the subsequent etching. Using suitable etching techniques, the layers **215**, **205** and **200** are selectively removed, down to the desired isolation depth **d1**, leaving polysilicon portions **280** and tunnel oxide portions **290**. In particular, an anisotropic etching is performed, thereby the etch rate is much higher vertically than laterally.

Then, the trenches **225** are filled with an insulator, for example, albeit not limitatively field silicon dioxide **230**. In such a way, isolation regions **270** are formed, adapted to isolate from each other active areas **275** in the substrate **200**, which active areas **275** will form the channel regions of the memory cells. The etching steps leading to the formation of the isolation regions **270** also define (in the direction of the word lines) the polysilicon portions **280** (*i.e.,* the floating gates of the memory cells); the floating gates **280** result self-aligned to the isolation regions **270.**

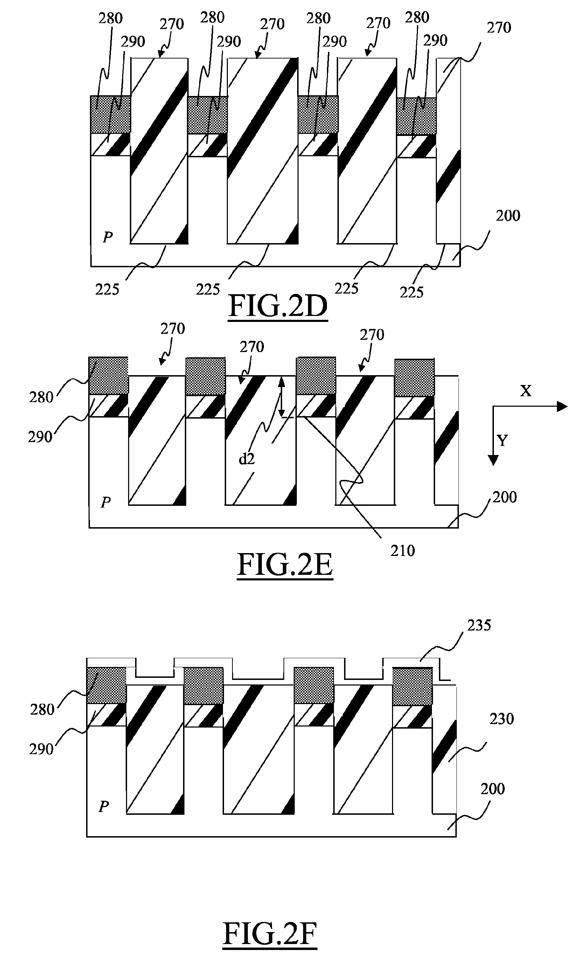

As shown in **Figure 2D**, the field silicon dioxide layer **230** is then planarized down to the nitride silicon layer **220,** for example by means of a CMP (acronym for Chemical Mechanical Planarization) process; the silicon nitride layer **220** is used as a stopping layer for stopping the planarization process. Then, the remaining portions of the silicon nitride layer **220** are etched away.

Moving to **Figure 2E,** the field oxide layer **230** is selectively etched using as an etching mask the polysilicon floating gates **280.** In particular, the etching process is selective against polysilicon and it can be both isotropic or anisotropic with respect to two directions **X** (lateral) and **Y** (vertical).

Specifically, the field oxide layer **230** corresponding to each isolation region **270** is etched to a depth such as to protrude a distance **d2** from the main surface **210**. The distance **d2** is chosen so as to ensure that the tunnel oxide portions **290** are not affected during the etching of the field oxide layer **230**. In particular, the distance **d2** may range from approximately 30nm to approximately 80nm.

As shown in **Figure 2F**, a relatively thin, conforming layer **235** of dielectric is deposited, for example by means of a CVD process, over the surface of the wafer; the conforming layer has a thickness such as to substantially follow the profile of the underlying layers. For example, the conforming layer **235** consists of a silicon nitride layer.

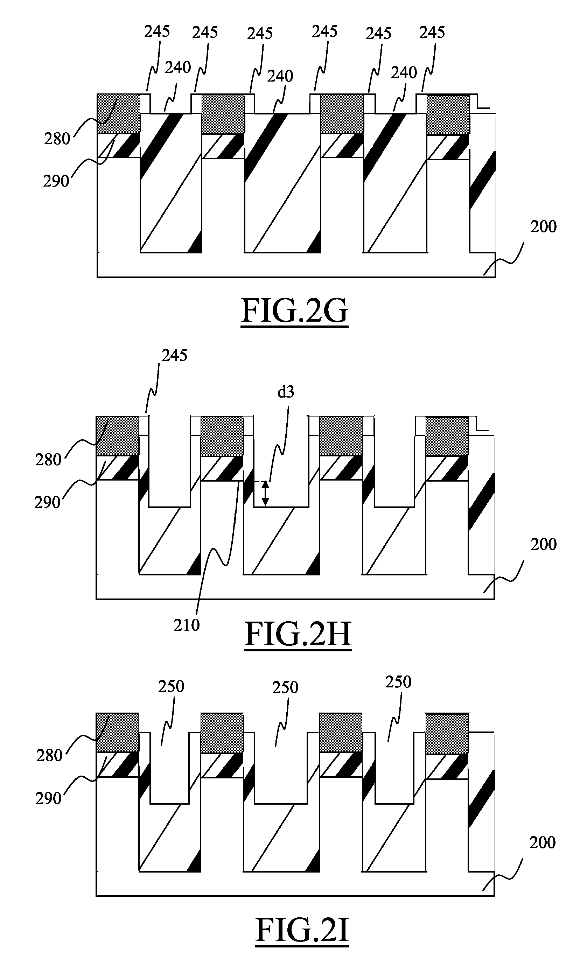

Moving to **Figure 2G**, the conforming layer **235** is then selectively etched by means of an anisotropic etching process, so that the conforming layer **235** is essentially only removed from the horizontal exposed surfaces, thus leaving exposed field oxide portions **240** of the field oxide layer **230** and the surface of the floating gates **280**. In such a way, silicon nitride spacers **245** are formed adjacent the vertical walls of the floating gates **280**.

As shown in **Figure 2H**, the exposed field oxide portions **240** are then etched by means of an etching process highly selective for silicon dioxide, that uses as a mask the silicon nitride spacers **245** and the floating gates **280**. The etching process must be anisotropic such that the exposed field oxide portions **240** are etched preferably along the vertical direction, down to a depth **d3** past the level of tunnel oxide portions **290** (*i.e.,* a surface of the field oxide portions after the etching is recessed the depth **d3** from the main surface **210).** In particular, and by way of example, the depth **d3** ranges from approximately 10nm to approximately 30nm.

Moving to **Figure 21,** the silicon nitride spacers **245** are then removed by a suitable selective etching process, leaving between adjacent floating gates **280** recessed windows **250** adapted for accommodating subsequent material layers.

Then, as shown in **Figure 2L,** a relatively thin, conforming interpoly dielectric layer **255** is deposited, for example by means of a CVD process, over the surface of the wafer, thus covering the walls of the recessed windows **250.** The interpoly dielectric layer **255** may for example consist of a stack of layers SiO₂/Si₃N₄/SiO₂, referred to as ONO (acronym for Oxide/Nitride/Oxide) layer. The ONO layer **255** is relatively thin (for example, the thickness of the ONO layer **255** ranges from 10nm to 18nm). Afterwards, a polysilicon layer **260** is deposited over the whole surface, such as to substantially completely fill the recessed windows **250.** The polysilicon layer **260** is then patterned to define word lines, each of which forms a common control gate for the memory cells of the word line. In particular, according to a conventional scheme, the polysilicon layer **260** and the ONO stack of layers **255** are etched, and at the same time the polysilicon floating gates **280** are defined in the direction orthogonal to the plane of the drawings. The complex of known operations follow that lead to the finished memory device.

Thanks to the fact that the polysilicon layer **260** fills the recessed windows **250,** the coupling capacitances between the floating gates of adjacent memory cells are strongly reduced. In fact, the polysilicon layer **260** filling the recessed windows **250,** being conductive, shields the floating gate of the generic selected cell from effects due to the charges stored on the floating gates of the adjacent cells.

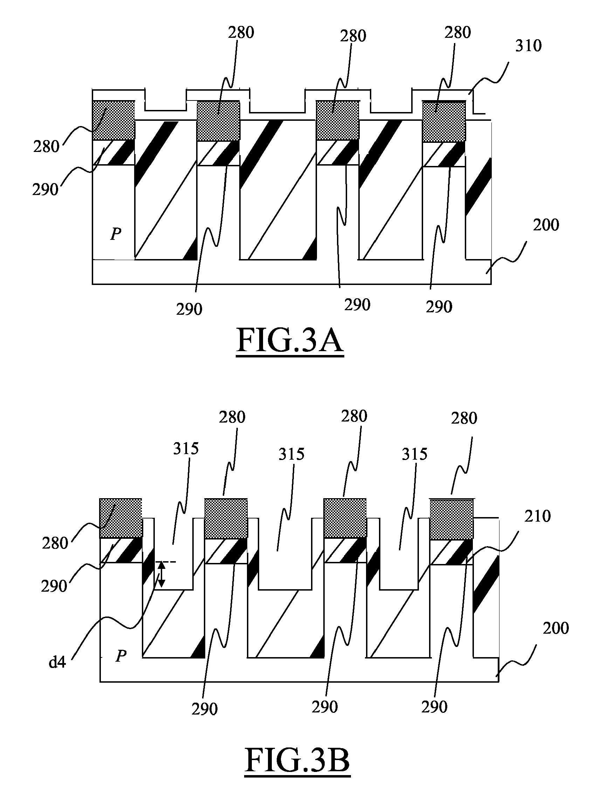

An alternative to the sequence of process phases just described, according to a second embodiment of the invention, consists in replacing the formation phase of the silicon nitride spacers **245** with the following process phases, shown in **Figures 3A-3B.**

In detail, the process proceeds similarly to the one described above up to the etching of the portions of field oxide layer **230** within the trenches **225 (Figure 2E).** Then, as shown in **Figure 3A,** a relatively thin, conforming silicon oxide layer **310** is deposited, for example by means of CVD process, over the surface of the wafer. The thickness of the silicon oxide layer **310** is such that the layer **310** substantially follows the profile of the underlying layers (for example, the thickness may range from about 10 nm to about 30nm).

Referring to **Figure 3B**, the silicon oxide layer **310** and the portions of the field oxide layer **230** within the trenches **225** are etched by means of an anisotropic etching process down to a depth **d4** past the level of the tunnel oxide portions **290,** that is, the exposed surface of the field oxide filling the trenches is recessed from the main surface **210** a depth **d4,** which in particular may be equal to the depth **d3** of the previous embodiment. The etching has an isotropic degree such that the layer **310** and the portions of field oxide filling the trenches **225** are etched preferably along the vertical direction. Thanks to the presence of the silicon oxide layer **310,** as well as to the anisotropy of the etching process, it is avoided that the tunnel oxide portions **290** are etched during this phase.

As a result of the etching, recessed windows **315** are formed between the adjacent floating gates **280,** which are adapted for accommodating the subsequent ONO layer **255** and polysilicon layer **260.** From now on, the process proceeds following a known process scheme, particularly the patterning and defmition of the word lines, that brings to the finished memory device.

Also in this embodiment, as mentioned in the foregoing, the recessed windows **315,** being filled by conductive polysilicon layer, shielding the floating gates of adjacent memory cells and reduce the coupling capacitances there between. The floating gate potential of the generic selected memory cell is thus not affected by the charge present on the floating gates of the adjacent cells.

By the method just described, thanks to the present invention it is possible to make a floating gate non-volatile memory device of very reduced size, wherein nevertheless the coupling capacitances with, and thus the effects of the adjacent memory cells of the memory matrix are very reduced.

Thanks to the present invention, the above results is achieved by means of relatively simple process steps and without adding masks respect to the reference process flow.

Moreover, it is particularly useful to apply the solution of the invention to multi-level flash memories, wherein the reduced threshold voltage margins between the different programming states makes the correct operation of the memory cells particularly critical in the presence of coupling capacitances between adjacent cells.

Moreover, the method according to the invention is very advantageous in the case of NOR and NAND flash type or multilevel floating-gate non volatile semiconductor memory devices, but it can be applied to any semiconductor device in which is necessary to have a reduced coupling capacitance between adjacent memory cells.

Naturally, in order to satisfy local and specific requirements, a person skilled in the art may apply to the solution described above many modifications and alterations. Particularly, although the present invention has been described with a certain degree of particularity with reference to preferred embodiments thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

For example, although in the preceding description reference has been made to a P-type substrate, the conductivity type of the region may be reversed.

In addition, it is not strictly necessary that the recessed windows **250** or **315** extend past the level of the tunnel oxide layer: significant reduction of the coupling capacitances may also be obtained with more shallow recessed windows.

Moreover, the recessed windows may have different shapes.

The shape and depth of the trenches may greatly vary.

In addition, it is possible to use other profiles of the dopant concentrations.

In any case, the use of alternative processes for realizing the proposed floating gate MOS transistor is possible.

For example, it is possible to grow a sacrificial oxide layer over the substrate before forming the tunnel oxide layer.

Moreover, before filling the trenches with the insulating layer, a thin layer of silicon oxide may be formed to cover the walls of the trenches.

In addition, although in the preceding description of the first invention embodiment a conforming nitride layer is deposited in order to form the spacers, a stack of relatively thin, conforming silicon dioxide layer and nitride layer may be formed.

## Claims

1. A process for manufacturing a non-volatile memory cell including a floating gate MOS transistor, comprising the steps of:
forming a gate dielectric **(290)** over a surface **(210)** of a semiconductor material layer **(200);**
forming a conductive floating gate electrode **(280)** insulated from the semiconductor material layer by the gate dielectric;
forming at least one isolation region **(270)** laterally to said floating gate electrode;
excavating the at least one isolation region;
filling the excavated isolation region with a conductive material; and
forming a conductive control gate electrode **(260)** of the floating gate MOS transistor insulatively over the floating gate,
**characterized in that**
the step of forming the floating gate electrode includes:
laterally aligning said floating gate electrode to the at least one isolation region; and
the step of excavating includes:
lowering an isolation region exposed surface below a floating gate electrode exposed surface, said lowering exposing walls of the floating gate electrode;
forming a protective layer on exposed walls of the floating gate electrode; and
etching the at least one isolation region essentially down to the gate dielectric, the protective layer protecting against etching a portion of the at least one isolation region near the gate dielectric.

2. The method according to claim 1, wherein the steps of forming the gate dielectric **(290),** forming the conductive floating gate electrode **(280)** and forming the at least one isolation region **(270)** includes:
forming a gate dielectric layer **(205)** over the main surface **(210)** of the semiconductor material layer **(200);**
forming a conductive floating gate layer **(215);**
forming at least one trench **(225)** extending into the semiconductor material layer, wherein said forming the at least one trench includes defining said floating gate electrode in a self-aligned way to the trench;
forming an insulating layer **(230),** said insulating layer filling the at least one trench.

3. The method according to claim 2, wherein the step of filling the at least one trench **(225)** includes:
planarizing the insulating layer **(230)** through a chemical mechanical polishing process.

4. The method according to claim 2 or 3, wherein said forming the at least one trench **(225)** includes:
forming a stopping layer **(220)** over the conductive floating gate layer **(215).**

5. The method according to claim 4, wherein the stopping layer **(220)** includes a silicon nitride layer.

6. The method according to any one of the preceding claims, wherein the step of lowering includes etching the planarized insulating layer.

7. The method according to any one of the preceding claims, wherein the step of forming the protective layer includes:
forming a conforming insulating layer **(235)** over the isolation region exposed surface and on the exposed walls of the floating gate electrode; and
anisotropically etching the conforming insulating layer **(235)** so as to form sidewall spacers **(245)** adjacent the walls of the floating gate electrode **(280).**

8. The method according to claim 7, wherein the conforming insulating layer **(235)** includes a first silicon nitride layer.

9. The method according to claim 7, wherein the conforming insulating layer **(235)** includes a sequence of an oxide layer and a silicon nitride layer.

10. The method according to any one of the claims from 1 to 6, wherein the step of forming the protective layer includes:
forming a conforming insulating layer **(310)** over the isolation region exposed surface and on the exposed walls of the floating gate electrode **(280);** and
selectively etching the conforming insulating layer.

11. The method according to claim 10, wherein the conforming insulating layer **(310)** includes a silicon oxide layer.

12. The method according to any one of the preceding claims, wherein said filling the excavated isolation region with a conductive material and forming a conductive control gate electrode **(260)** of the floating gate MOS transistor includes:
depositing a polycrystalline silicon layer, and
patterning the polycrystalline silicon layer to form the conductive control gate electrode.

13. A floating gate MOS transistor, comprising
a conductive floating gate electrode **(280)** insulated from a semiconductor material layer **(200)** by means of a gate dielectric layer **(205),** said semiconductor material layer having a main surface **(210);**
at least one isolation region **(270)** lateral to said floating gate electrode;
an excavation formed in the isolation region, and a conductive material filling the excavation;
a conductive control gate electrode **(260)** of the floating gate MOS transistor
**characterized in that**
said floating gate electrode is laterally aligned to the at least one isolation region.

14. The floating gate MOS transistor of claim 13, wherein said conductive material filling the excavation also forms said conductive control gate electrode **(260).**

15. A method of manufacturing a semiconductor memory device, comprising:
forming an arrangement of memory cells, each memory cell including a floating gate MOS transistor, and
isolating the memory cells from each other by means of isolation regions **(270),**
wherein said memory cells are formed according to any claim from 1 to 12.

16. A Semiconductor memory device comprising a matrix of memory cells each one isolated by adjacent memory cells by means of isolation regions **(270), characterized in that** said memory cells are according to claim 13 or 14.

17. The semiconductor memory device according to claim 16, wherein said memory cells are arranged to form a NAND or NOR architecture.
